(19) Europäisches Patentamt
European Patent Office
Office européen des brevets

(11) Publication number: **0 260 110 B1**

(12) **EUROPEAN PATENT SPECIFICATION**

(45) Date of publication of patent specification: **08.07.92** (51) Int. Cl.$^5$: **H01L 33/00**

(21) Application number: **87307928.9**

(22) Date of filing: **08.09.87**

(54) **A double heterostructure light emitting diode.**

(30) Priority: **12.09.86 JP 216505/86**

(43) Date of publication of application:
**16.03.88 Bulletin 88/11**

(45) Publication of the grant of the patent:
**08.07.92 Bulletin 92/28**

(84) Designated Contracting States:
**DE FR GB**

(56) References cited:
**EP-A- 0 140 645**
**US-A- 4 184 170**

**JOURNAL OF LIGHTWAVE TECHNOLOGY, vol. LT-3, no. 6, December 1985, pages 1217-1222, IEEE, New York, US; A. SUZUKI et al.: "InGaAsP/InP 1.3-mum wavelength surface-emitting LED's for high-speed short-haul optical communication systems"**

**SOVIET JOURNAL OF OUANTUM ELECTRONICS, vol. 16, no. 7, July 1986, pages 902-905, American Institute of Physics, New York, NY, US; P.G. ELISEEV et al.: "Light-emission and degradation characteristics of InGaAsP/InP heterostructures"**

(73) Proprietor: **NEC CORPORATION**
**7-1, Shiba 5-chome Minato-ku**
**Tokyo 108-01(JP)**

(72) Inventor: **Uji, Toshio c/o NEC Corporation**
**7-1, Shiba 5-chome**
**Minato-ku Tokyo108-01(JP)**

(74) Representative: **Pears, David Ashley et al**
**REDDIE & GROSE 16 Theobalds Road**
**London WC1X 8PL(GB)**

**EP 0 260 110 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

### FIELD OF THE INVENTION

The invention relates to a double heterostructure light emitting diode, and more particularly to a double heterostructure light emitting diode which is used for a light source in an optical communication system.

### BACKGROUND OF THE INVENTION

One of conventional double heterostructure light emitting diodes is described on pages 1217 to 1222 of "Journal of Lightwave Technology, Vol LT-3 No.6" published in December of 1985. The double heterostructure light emitting diode comprises a buffer layer of Sn doped n-InP, an active layer of Zn doped $p^+$ -InGaAsP, a cladding layer of Zn doped p-InP, a confining layer of Sn doped n-InGaAsP, a capping layer of Zn doped p-InGaAsP, and a $SiO_2$ film respectively in turn provided on an n-InP substrate. The double heterostructure light emitting diode further comprises a p-electrode provided on the $SiO_2$ film, an n-electrode having a light emitting window provided on the back surface of the n-InP substrate, and a Zn diffused region of a predetermined diameter built in the confining layer wherein the p-electrode is partly projected into a current injecting aperture of the $SiO_2$ film to be in contact with the Zn-diffused region extending through the capping layer over the confining layer.

According to the double heterostructure light emitting diode described above, the active layer is heavily doped with p-impurity like Zn to shorten the life time of carriers so that a high speed response is obtained. In one of the results, a rise and fall times of light input are both as fast as 350 ps using a specified speedup circuit and applying DC bias offset.

In the conventional double heterostructure light emitting diode, however, light output is considerably decreased because the active layer is heavily doped with such a p-impurity as Zn etc., although a response time is increased in accordance with the increase of the impurity concentration therein. Further, the crystal surface of the active layer tends to be rough due to the high concentration doping thereinto so that a yield is decreased in fabricating such a light emitting diode. For this reason, there is resulted in a limitation in obtaining a high speed response in a light emitting diode comprising an active layer to be doped with such a p-impurity as Zn etc.

Alternatively, it must be adopted that a peaking of pulses is performed in a rise and fall thereof in a circuit for driving a light emitting diode, or that DC biased voltage is applied thereto to obtain a high speed response, if an active layer thereof is not heavily doped with a p-impurity.

An example of a double heterostructure light emitting diode which seeks to avoid the above-mentioned problems caused by heavy p-impurity doping of the active region is described in EP-A-0140645 (Sumitomo). The device comprises a cladding layer of Te doped n-InP, an active layer of undoped InGaAsP, an active layer of Zn doped p-InGaAsP, a cladding layer of Zn doped p-InP, and a contact layer of Zn doped p-InGaAsP respectively in turn formed on a Te doped n-InP substrate. It is an object of the Sumitomo invention to increase yield rate and reliability of the device by the interposition of the undoped InGaAsP active layer between the n-InP claddding layer and the p-InGaAsP active layer.

### SUMMARY OF THE INVENTION

Accordingly, it is an object of the present invention to provide a double heterostructure light emitting diode in which a high speed response is obtained without deteriorating a characteristic of light output.

It is a further object of the present invention to provide a double heterostructure light emitting diode in which a high speed response is obtained without decreasing a fabricating yield thereof.

It is a still further object of the invention to provide a double heterostructure light emitting diode in which a high speed response is obtained without relying upon specified controls in a circuit for driving a light emitting diode.

According to the invention, a double heterostructure light emitting diode comprises,

a double heterostructure provided on a semiconductor substrate including a p-active layer, and n and p-cladding layers respectively provided on the two sides of the p-active layer, and

means for applying a predetermined level of voltage across the n and p-cladding layers,

characterised in that the p-active layer is so doped with a p-impurity that the impurity concentration thereof is higher proximate to the p-n junction between the p-active layer and the n-cladding layer.

### BRIEF DESCRIPTION OF THE DRAWINGS

The invention will be explained in more detail in accordance with following drawings wherein,

Fig. 1 is a cross sectional view illustrating a double heterostructure light emitting diode in the first embodiment according to the invention,

Fig. 2 is a cross sectional view illustrating a double heterostructure light emitting diode in the second embodiment according to the invention, and
Figs. 3A and 3B are explanatory diagrams showing p-impurity concentration in an active layer.

## DESCRIPTION OF THE PREFERRED EMBODIMENT

In Fig. 1, there is shown a double heterostructure light emitting diode in the first embodiment according to the invention. In fabricating the double heterostructure light emitting diode, an n-cladding layer 12 of n-InP, a p-high concentration region 13 of p-InGaAsP which is doped with Zn by $1x10^{19}$ $cm^{-3}$ in its concentration to be of 0.1$\mu$m in its thickness, a p-low concentration region 14 of p-InGaAsP which is doped with Zn by $7x10^{18}cm^{-3}$ in its concentration to be of 0.4$\mu$m in its thickness, a p-cladding layer 15 of InP, and a contact layer 16 of p-InGaAsP are sequentially provided on a semiconductor substrate 11 of n-InP. In the structure described above, an active layer 30 is composed of the p-high and low concentration regions 13 and 14.

Next, a $SiO_2$ film 17 is provided on the contact layer 16, and a current injecting aperture 18 is then formed to be of 20$\mu$m in its diameter in accordance with the preferential etching of the $SiO_2$ film covered with a photoresist. Thereafter, a p-electrode 19 of TiPt film is provided on the $SiO_2$ film 17 and in the current injecting aperture 18.

Then, an n-electrode 21 of AuGe film is provided so as to have a light emitting window 20 on the back surface of the semiconductor substrate 11 which is polished to be of approximately 100 $\mu$m in its thickness.

In the double heterostructure light emitting diode thus fabricated, the p-high concentration region 13 is provided in the active layer 30 to be in contact with a p-n junction so that a higher speed of electron-hole recombination is obtained in the p-high concentration region 13. This means that electrons are rapidly recombined with holes in the active layer 30, when a driving pulse is turned off in a circuit for driving the light emitting diode. As a result, a waveform of light output falls sharply so that a fall time thereof is shortened.

As compared to a conventional double heterostructure light emitting diode which does not have such a structure as the p-high concentration region 13, a fall time of light output is shortened by more than 40% in the first embodiment according to the invention, as far as light output is maintained to be the same level. On the other hand, light output is increased in its level as much as approximately 50% in a case where a fall time thereof is maitained to be the same as that in the conventional light emitting diode. As apparent from these results, a double heterostructure light emitting diode in which a high power light output and high speed response are obtained is provided in the invention.

Further, a yield in fabricating a double heterostructure light emitting diode according to the invention is improved for the reason why a roughness on the surface of the p-high concentration region 13 is no matter in regard to a characteristic thereof because the p-low concentration region 14 is provided directly thereon to provide the active layer 30.

In Fig. 2, there is shown a double heterostructure light emitting diode in the second embodiment according to the invention wherein like parts are designated by like reference numerals except that a $SiO_2$ film, current injecting aperture and p-electrode are designated respectively by 17a, 18a and 19a so that repeated explanations are omitted here. The double heterostructure light emitting diode is provided with a circular groove 22 being extended through an active layer 30 thereby resulting in a current confining therein, although a p-impurity concentration is distributed in the active layer 30 in the same manner as the first embodiment.

In the double heterostructure light emitting diode in the second embodiment, a parasitic capacitance is much decreased in the existence of the groove 22 so that a response time is much more shortened. Further, an efficiency in coupling light from the light emitting diode to an optical fiber is improved to a great extent for the reason why light emitting intensity is distributed uniformly because current is transversely confined by the groove 22.

As compared to a double heterostructure light emitting diode in the first embodiment, a fall time of light output is shortened as much as a half, while light output is increased in its level as much as 60% in the second embodiment.

In the first and second embodiments, although a p-impurity concentration is distributed in the active layer 30 to be varied in a step-like manner in a direction of thickness thereof as shown in Fig. 3A, it may be varied gradually in a continuous manner as shown in Fig. 3B thereby to result in the same effects. Such a distribution of p-impurity concentration is easily carried out by a vapour phase epitaxial growth method.

In operation, carriers injected into the active layer 30 are extinguished in accordance with the recombination thereof during the time when a voltage applied across the p and n-electrodes 19 and 21 becomes zero due to the turning off of a driving pulse applied thereacross. A fall time of light output is determined by the extinction of electrons in the active layer 30 because the active layer 30 is doped with p-impurity. At this moment, electrons are collected along the p-n junction in the active layer 30, that is, on the side of the n-cladding layer 12 due to the space charge of the p-n junction. In the light emitting diode according to the invention, especially, much faster extinction time during which electrons are recombined with holes is obtained for the reason why a p-impurity concentration is distributed to be higher in the region proximate to the p-n junction in the active layer 30, in other words, a p-impurity concentration is higher in the region where electrons are collected. As a result, a fall time of light output is extremely shortened.

On the other hand, an improvement is obtained in regard to light output when a driving pulse is turned on, that is, high current injection is performed. At the time of high current injection, carriers are distributed in the whole region of the active layer 30. In the light emitting diode according to the invention, higher light output is produced in spite of the fact that light emitting efficiency is generally deteriorated in accordance with the increase of p-impurity concentration for the reason why a p-impurity concentration is not so high in the whole region of the active layer 30 because a p-impurity concentration is made partly higher therein.

As described above, higher light output is produced at the time of pulse-on, while a fall time of light output is remarkably shortened at the time of pulse-off because a p-impurity concentration is distributed to be higher partly in the active layer 30.

## Claims

1. A double heterostructure light emitting diode, comprising a double heterostructure provided on a semiconductor substrate (11) and including a p-active layer (13,14) and n and p-cladding layers (12,15) respectively provided on the two sides of the p-active layer, and means (19,21) for applying a predetermined level of voltage across the n and p-cladding layers, characterised in that the p-active layer (13,14) is so doped with p-impurity that the concentration thereof is higher proximate to the p-n junction between the p-active layer and the n-cladding layer (12).

2. A double heterostructure light emitting diode according to claim 1, characterised in that the active layer is composed of high and low p-impurity concentration regions (13 and 14).

3. A double heterostructure light emitting diode according to claim 1, characterised in that the p-impurity concentration in the active layer (13,14) reduces in a continuous manner from the n-cladding layer (12) to the p-cladding layer (15).

4. A double heterostructure light emitting diode, comprising, in order,
   a semiconductor substrate (11) of n-InP,
   a cladding layer (12) of n-InP,
   a first layer (13) of p-InGaAsP,
   a second layer (14) of p-InGaAsP,
   a cladding layer (15) of p-Inp,
   a contact layer (16) of p-InGaAsP,
   and a $SiO_2$ film (17) having a current injecting aperture (18), a p-electrode (19) provided on the $SiO_2$ film and in the current injecting aperture thereof, and an n-electrode (21) having a light emitting window (20) provided on the back surface of the semiconductor substrate, wherein an active layer (13,14) is composed of the said first and second layers of p-InGaAsP, the first layer having a higher p-impurity concentration than the second layer.

5. A double heterostructure light emitting diode, according to claim 4, further comprising a circular groove (20) extending through the active layer (13,14) and wherein the $SiO_2$ film (17) and p-electrode (19) are also provided on the surface of the circular groove.

## Revendications

1. Diode électroluminescente à double hétérostructure, comprenant une double hétérostructure disposée sur un substrat semi-conducteur (11) et comportant une couche active p (13, 14) ainsi que des couches de gainage n et p (12, 15) appliquées respectivement sur les deux côtés de la couche active p, et un moyen (19, 21) pour appliquer un niveau de tension prédéterminé aux bornes des couches de gainage n et p, caractérisée en ce que la couche active p (13, 14) est dopée avec des impuretés-p de telle façon que la concentration de celles-ci est plus grande au voisinage de la jonction p-n entre la couche active p et la couche de gainage n (12).

2. Diode électroluminescente à double hétérostructure selon la revendication 1, caractérisée en ce que la couche active est composée de régions à haute et faible concentrations d'impuretés-p (13 et 14).

3. Diode électroluminescente à double hétérostructure selon la revendication 1, caractérisée en ce que la concentration d'impuretés-p dans la couche active (13, 14) diminue de manière continue de la couche de gainage n (12) à la couche de gainage p (15).

4. Diode électroluminescente à double hétérostructure comprenant, dans l'ordre :

un substrat semi-conducteur (11) de InP-n,
une couche de gainage (12) de InP-n,
une première couche (13) de InGaAsP-p,
une seconde couche (14) de InGaAsP-p,
une couche de gainage (15) de InP-p,
une couche de contact (16) de InGaAsP-p, et

un film de $SiO_2$ (17) qui comporte une ouverture d'injection de courant (18), une électrode p (19) étant disposée sur le film de $SiO_2$ et dans l'ouverture d'injection de courant de celui-ci, et une électrode n (21) qui comporte une fenêtre d'émission de lumière (20) étant disposée sur la surface arrière du substrat semiconducteur, dans laquelle une couche active (13, 14) est constituée des première et seconde couches de InGaAsP-p, la première couche comportant une concentration d'impuretés-p plus grande que la seconde couche.

**5.** Diode électroluminescente à double hétérostructure selon la revendication 4, comprenant en outre une rainure circulaire (20) qui s'étend à travers la couche active (13, 14) et dans laquelle le film de $SiO_2$ (17) et l'électrode p (19) sont, également disposés sur la surface de la rainure circulaire.

## Patentansprüche

**1.** Licht emittierende Diode mit doppelter Heterostruktur mit einer auf einem Halbleitersubstrat (11) vorgesehenen Doppelheterostruktur, die eine p-Aktivschicht (13, 14) und n- und p-Abdeckschichten (12, 15) aufweist, die jeweils auf den zwei Seiten der p-aktiven Schicht vorgesehen sind, und eine Einrichtung (19, 21) zum Anlegen eines bestimmten Spannungspegels über der n- und p-Überzugsschicht, **dadurch gekennzeichnet,** daß die p-Aktivschicht (13, 14) so mit p-Verunreinigungen dotiert ist, daß ihre Konzentration benachbart zu dem p-n-Übergang zwischen der p-Aktivschicht und der n-Abdeckschicht (12) höher ist.

**2.** Licht emittierende Diode mit doppelter Heterostruktur nach Anspruch 1, **dadurch gekennzeichnet**, daß die aktive Schicht aus Bereichen (13, 14) mit höherer und niedrigerer p-Verunreinigungskonzentration zusammengesetzt ist.

**3.** Licht emittierende Diode mit doppelter Heterostruktur nach Anspruch 1, dadurch gekennzeichnet, daß die p-Verunreinigungskonzentration in der aktiven Schicht (13, 14) sich in kontinuierlicher Weise von der n-Abdeckschicht (12) zu der p-Abdeckschicht (15) verringert.

**4.** Licht emittierende Diode mit doppelter Heterostruktur mit in folgender Reihenfolge

einem Halbleitersubstrat (11) aus n-InP,
einer Abdeckschicht (12) aus n-InP,
einer ersten Schicht (13) aus p-InGaAsP,
einer zweiten Schicht (14) aus p-InGaAsP,
einer Abdeckschicht (15) aus p-InP,
einer Kontaktschicht (16) aus p-InGaAsP,
und einem $SiO_2$-Film (17) mit einer Stromzuführöffnung (18), einer p-Elektrode (19), die auf dem $SiO_2$-Film und in dessen Stromzuführöffnung vorgesehen ist, und einer n-Elektrode (21) mit einem Lichtemissionsfenster (20), das auf der Rückseite des Halbleitersubstrats vorgesehen ist, wobei eine aktive Schicht (13, 14) aus der ersten und der zweiten Schicht aus p-InGaAsP zusammengesetzt ist, wobei die erste Schicht eine höhere p-Verunreinigungskonzentration als die zweite Schicht hat.

**5.** Licht emittierende Diode mit doppelter Heterostruktur nach Anspruch 4, ferner mit einer kreisförmigen Nut (20), die sich durch die aktive Schicht (13, 14) erstreckt und wobei der $SiO_2$-Film (17) und die p-Elektrode (19) ebenfalls auf der Oberfläche der kreisförmigen Nut vorgesehen sind.

FIG. 1

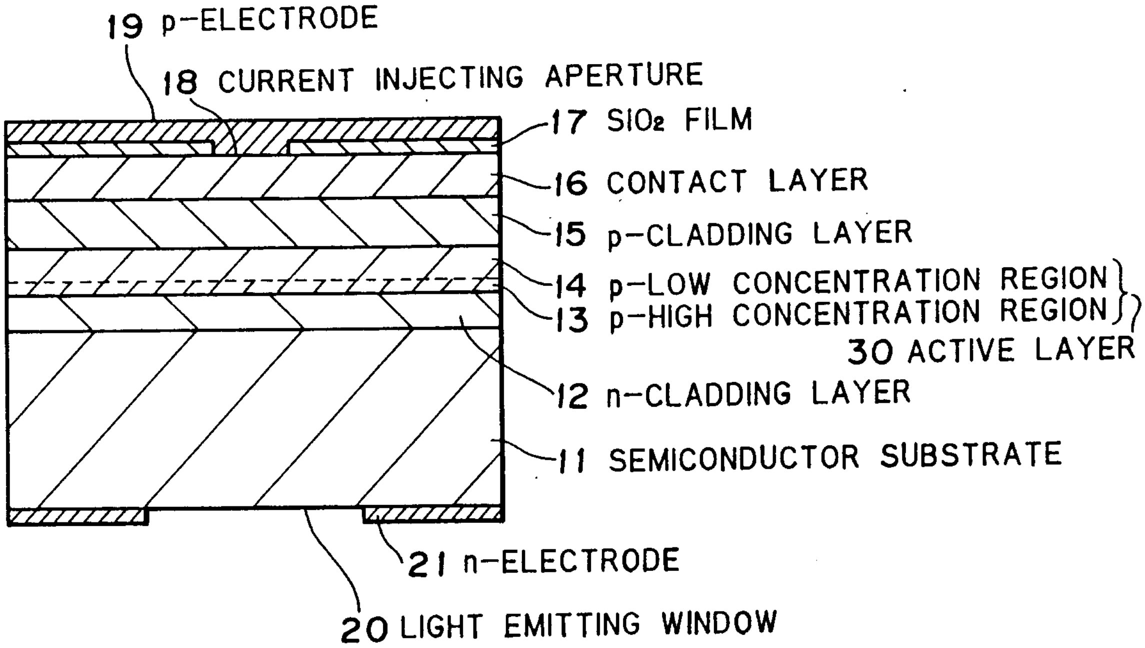
19 p-ELECTRODE
18 CURRENT INJECTING APERTURE
17 $SiO_2$ FILM
16 CONTACT LAYER
15 p-CLADDING LAYER
14 p-LOW CONCENTRATION REGION
13 p-HIGH CONCENTRATION REGION
30 ACTIVE LAYER
12 n-CLADDING LAYER
11 SEMICONDUCTOR SUBSTRATE
21 n-ELECTRODE
20 LIGHT EMITTING WINDOW

FIG. 2

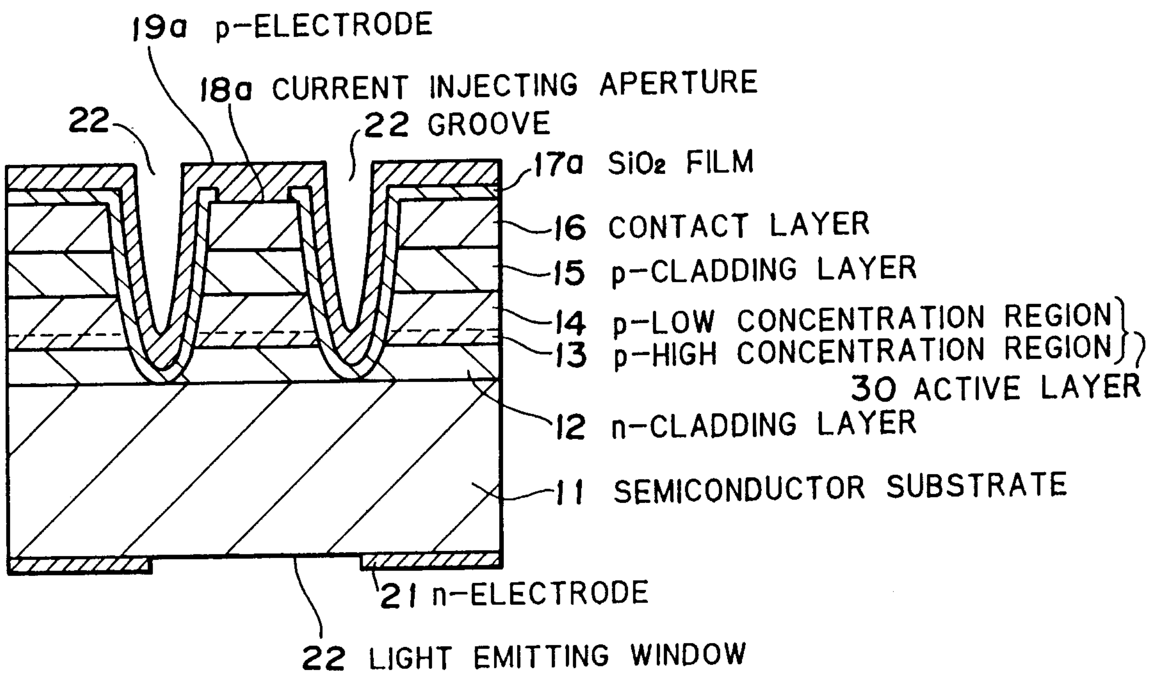
19a p-ELECTRODE
18a CURRENT INJECTING APERTURE
22
22 GROOVE
17a $SiO_2$ FILM
16 CONTACT LAYER
15 p-CLADDING LAYER
14 p-LOW CONCENTRATION REGION
13 p-HIGH CONCENTRATION REGION
30 ACTIVE LAYER
12 n-CLADDING LAYER
11 SEMICONDUCTOR SUBSTRATE
21 n-ELECTRODE
22 LIGHT EMITTING WINDOW

FIG. 3A

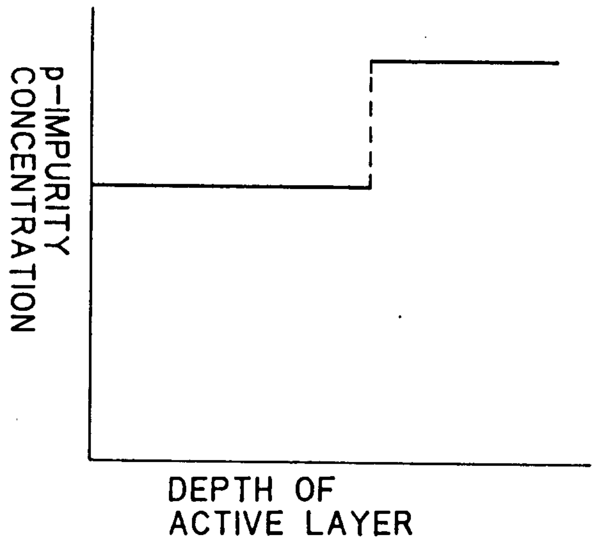
p-IMPURITY
CONCENTRATION
DEPTH OF
ACTIVE LAYER

FIG. 3B

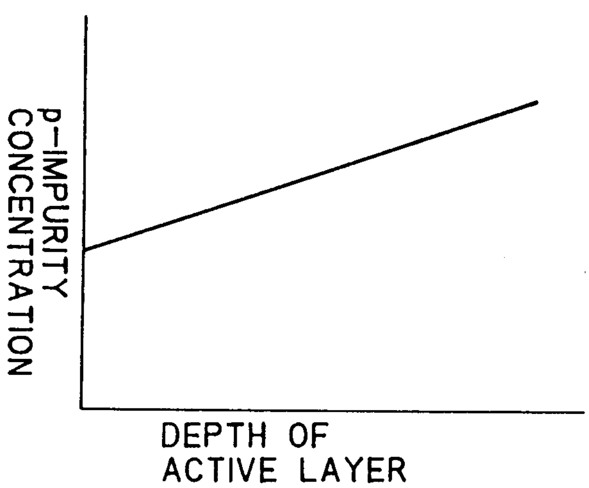
p-IMPURITY
CONCENTRATION
DEPTH OF
ACTIVE LAYER